(19) **Europäisches Patentamt / European Patent Office / Office européen des brevets**

(11) **EP 4 580 044 A1**

(12) **EUROPEAN PATENT APPLICATION**
published in accordance with Art. 153(4) EPC

(43) Date of publication:
**02.07.2025 Bulletin 2025/27**

(21) Application number: **22959860.2**

(22) Date of filing: **27.09.2022**

(51) International Patent Classification (IPC):
*H02S 50/10* *(2014.01)*

(52) Cooperative Patent Classification (CPC):
**H02S 50/10**

(86) International application number:
**PCT/CN2022/121866**

(87) International publication number:
**WO 2024/065211 (04.04.2024 Gazette 2024/14)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(71) Applicant: **Contemporary Amperex Technology Co., Limited**
**Ningde, Fujian 352100 (CN)**

(72) Inventors:
- LIU, Diping
  **Ningde, Fujian 352100 (CN)**
- LIN, Longzhen
  **Ningde, Fujian 352100 (CN)**
- YAN, Yu
  **Ningde, Fujian 352100 (CN)**

(74) Representative: **Ziebig Hengelhaupt Intellectual Property Attorneys Patentanwaltskanzlei PartGmbB**
**Leipziger Straße 49**
**10117 Berlin (DE)**

(54) **PHOTOVOLTAIC ARRAY TEST METHOD AND SYSTEM**

(57) The present application provides a photovoltaic array test method and system, the method being applied to a photovoltaic array test system. The photovoltaic array test method comprises: obtaining the quantity of photovoltaic branches connected in a photovoltaic array; determining a reference electrical parameter according to the quantity of the photovoltaic branches and electrical parameters of the photovoltaic branches; if the photovoltaic array is electrically connected to the photovoltaic array test system, monitoring a test electrical parameter of the photovoltaic array; and determining a test result of the photovoltaic array according to the test electrical parameter and the reference electrical parameter.

Obtain the quantity of photovoltaic branches connected in a photovoltaic array — 310

Determine a reference electrical parameter according to the quantity of the photovoltaic branches and electrical parameters of the photovoltaic branches — 320

If the photovoltaic array is electrically connected to the photovoltaic array test system, obtain a test electrical parameter of the photovoltaic array — 330

Determine a test result of the photovoltaic array according to the test electrical parameter and the reference electrical parameter — 340

**FIG. 2**

**Description**

**TECHNICAL FIELD**

The present application relates to the technical field of photovoltaic power generation, and specifically relates to a photovoltaic array test method and system.

**BACKGROUND**

Before use, it is usually needed to test photovoltaic arrays. A current test method of the photovoltaic arrays is to test current and voltage of loops, carry out global scanning and compare the data with the preset value, and then determine whether there is an abnormality in the loop according to the difference value.

**SUMMARY OF THE INVENTION**

In view of this, an objective of the embodiments of the present application is to provide a photovoltaic array test method and system to relieve the limitation of photovoltaic branch test in the prior art.

In a first aspect, an embodiment of the present application provides a photovoltaic array test method, and the method is applied to a photovoltaic array test system. The photovoltaic array test method includes: obtaining the quantity of photovoltaic branches connected in a photovoltaic array; determining a reference electrical parameter according to the quantity of the photovoltaic branches and electrical parameters of the photovoltaic branches; if the photovoltaic array is electrically connected to the photovoltaic array test system, obtaining a test electrical parameter of the photovoltaic array; and determining a test result of the photovoltaic array according to the test electrical parameter and the reference electrical parameter.

In an optional embodiment, the step of if the photovoltaic array is electrically connected to the photovoltaic array test system, obtaining a test electrical parameter of the photovoltaic array includes: if the photovoltaic array is in a state of supplying power to the photovoltaic array test system, monitoring the test electrical parameter inputted by the photovoltaic array to the photovoltaic array test system.

In the above embodiment, the photovoltaic array is used as a power supply device to test the power supply condition of the photovoltaic array.

In an optional embodiment, the reference electrical parameter includes first reference current; the electrical parameters of the photovoltaic branches include first reference current of the photovoltaic branches; and the test electrical parameter includes first test current;

the determining a reference electrical parameter according to the quantity of the photovoltaic branches and electrical parameters of the photovoltaic branches includes: determining reference current of a single photovoltaic branch of the photovoltaic array according to a characteristic parameter of the single photovoltaic branch; and determining first reference current of the photovoltaic array according to the quantity of the photovoltaic branches and the reference current of the photovoltaic branches; and

the determining a test result of the photovoltaic array according to the test electrical parameter and the reference electrical parameter includes: comparing the first test current with the first reference current; and if the difference value between the first test current and the first reference current is greater than a first current threshold, determining that the photovoltaic array is abnormal.

In the above embodiment, when determining the reference current, the quantity of effective photovoltaic branches of the photovoltaic array can be computed, thus the computed first reference current can be more accurate, and then the result of testing the photovoltaic array can be more accurate.

In an optional embodiment, the determining reference current of a single photovoltaic branch of the photovoltaic array according to an electrical parameter of the single photovoltaic branch includes: determining first initial current of the single photovoltaic branch according to the characteristic parameter of the photovoltaic branch in a plurality of working states; and determining the reference current of the photovoltaic branch according to the first initial current in the plurality of working states.

In an optional embodiment, the characteristic parameter includes photocurrent and loss current of the photovoltaic branch; and

the determining first initial current of the photovoltaic branch according to the characteristic parameter of the photovoltaic branch includes: acquiring the photocurrent generated by the single photovoltaic branch; acquiring the loss current of the single photovoltaic branch; and determining the first initial current of the photovoltaic branch according to the photocurrent and the loss current.

In the above embodiment, when determining the first reference current, the loss current in the photovoltaic array is also taken into account, thus the determined first reference current can be more accurate, and furthermore, the result of testing the photovoltaic array can be more accurate.

In an optional embodiment, the determining reference current of the photovoltaic branch according to the first initial current in the plurality of working states includes: screening out the current corresponding to the power of the photovoltaic branch being greater than a set power from the first initial current in the plurality of working states as the reference current of the photovoltaic branch.

In the above embodiment, when the photovoltaic array works to supply power, the current corresponding to the maximum power point will be automatically selected as outputted working current, and therefore when determining the reference current, screening can be carried out based on this standard, the test can be in a state closer to the normal working state of the photovoltaic array, and the result of testing the photovoltaic array can be more accurate.

In an optional embodiment, the reference electrical parameter includes first reference voltage, and the test electrical parameter includes first test voltage; and

the determining a test result of the photovoltaic array according to the test electrical parameter and the reference electrical parameter includes: comparing the first test voltage with the first reference voltage, and if a difference value between the first test voltage and the first reference voltage is greater than a first voltage threshold, determining that the photovoltaic array is abnormal.

In the above embodiment, the voltage of the photovoltaic array can also be tested, and thus the test result of the photovoltaic array can be more comprehensive.

In an optional embodiment, the photovoltaic array test system includes: a power module; and

the step of if the photovoltaic array is electrically connected to the photovoltaic array test system, obtaining a test electrical parameter of the photovoltaic array includes:

if the power module of the photovoltaic array test system is in a state of supplying power to the photovoltaic array, monitoring the test electrical parameter of the photovoltaic array.

In the above embodiment, it can also be that the photovoltaic array performs secondary power supply, and thus the working condition of the photovoltaic array and the condition of internal components in the photovoltaic array can be tested more comprehensively.

In an optional embodiment, the reference electrical parameter includes second reference current; the electrical parameters of the photovoltaic branches include second reference current of the photovoltaic branches; and the test electrical parameter includes second test current;

the determining a reference electrical parameter according to the quantity of the photovoltaic branches and electrical parameters of the photovoltaic branches includes: for each photovoltaic branch, acquiring the load current of all load elements in the photovoltaic branch; determining the second reference current of the photovoltaic branch according to the load current of all the load elements; and determining the second reference current of the photovoltaic array according to the quantity of the photovoltaic branches and the second reference current of the photovoltaic branches; and

the determining a test result of the photovoltaic array according to the test electrical parameter and the reference electrical parameter includes: comparing the second test current with the second reference current, and if a difference value between the second test current and the second reference current is greater than a second current threshold, determining that the photovoltaic array is abnormal.

In the above embodiment, the photovoltaic branches do not actively supply power, so the photovoltaic branches do not have photocurrent, then the reference current different from that under active power supply of the photovoltaic array can be determined. Through the above mode of determining the reference current, the working condition of second work can be better met, and the test of the photovoltaic array under the condition can be realized.

In an optional embodiment, the reference electrical parameter includes second reference voltage, and the test electrical parameter includes second test voltage; and

the determining a test result of the photovoltaic array according to the test electrical parameter and the reference electrical parameter includes: comparing the second test voltage with the second reference voltage, and if a difference value between the second test voltage and the second reference voltage is greater than a second voltage threshold, determining that the photovoltaic array is abnormal.

In the above embodiment, the voltage under second power supply can be compared to more comprehensively determine whether the photovoltaic array is abnormal.

In an optional embodiment, the method further includes:

comparing the quantity of the connected photovoltaic branches with the total quantity of photovoltaic branches contained in the photovoltaic array, so as to determine whether the quantity of the connected photovoltaic branches is smaller than the total quantity of photovoltaic branches contained in the photovoltaic array or not; and if the quantity of the connected photovoltaic branches is smaller than the total quantity of photovoltaic branches contained in the photovoltaic array, determining that there is an abnormal connection in the photovoltaic array.

In the above embodiment, the quantity of the photovoltaic branches actually contained in the photovoltaic array can be compared with the quantity of photovoltaic branches successfully connected to the test system to determine whether there is an abnormal connection in the photovoltaic array, so that various abnormalities of the photovoltaic array can be positioned more accurately.

In a second aspect, an embodiment of the present application provides a photovoltaic array test system, which includes: a photovoltaic energy storage inverter; the photovoltaic energy storage inverter includes an input interface, a converter and a central controller;

the input interface is configured to connect the photovoltaic array;
the converter is configured to test an electrical parameter of the photovoltaic array; and
the photovoltaic energy storage inverter executes steps of the method during operation.

In an optional embodiment, the photovoltaic array test system further includes a power module connected to the photovoltaic energy storage inverter; and
the power module is configured to supply power to the photovoltaic array.

According to the photovoltaic array test method and system provided by the embodiments of the present application, the quantity of photovoltaic branches connected to the test system is tested, so that misjudgment caused by disconnection can be avoided; and in addition, the reference electrical parameter can be determined according to the quantity of the connected photovoltaic branches, so the determined reference values have high reference level, and whether the photovoltaic array has circuit abnormality or not can be determined more accurately.

In order to make the above objective, features and advantages of the present application more obvious and easier to understand, the following embodiments are provided for detail description with cooperation with the accompanying drawings.

## DESCRIPTION OF DRAWINGS

In order to more clearly illustrate the technical solutions of the embodiments of the present application, the accompanying drawings that need to be used in the embodiments will be briefly introduced below, and it is to be understood that the following accompanying drawings only show some embodiments of the present application and therefore should not be regarded as limiting the scope. For those skilled in the art, other relevant accompanying drawings can also be obtained based on these accompanying drawings without creative work.

FIG. 1 is a structural schematic diagram of a photovoltaic array test system provided by an embodiment of the present application;
FIG. 2 is a flowchart of a photovoltaic array test method provided by an embodiment of the present application;
FIG. 3 is an optional flowchart of a step 320 of a photovoltaic array test method provided by an embodiment of the present application;
FIG. 4 is an equivalent circuit diagram of a photovoltaic branch;
FIG. 5 is another optional flowchart of a step 320 of a photovoltaic array test method provided by an embodiment of the present application; and
FIG. 6 is an equivalent circuit diagram of a photovoltaic branch in a power supply state.

Reference numerals: 100-photovoltaic array test system; 110-photovoltaic energy storage inverter; 111-converter; 112-input interface; 113-DCAC inverter; 114-manual switch; 115-first current sensor; 116-test controller; 117-photovoltaic voltage; 118-central controller; 120-power module; 130-DCDC converter; and 200-photovoltaic array.

## DETAILED DESCRIPTION

The technical solution in the embodiment of the present application is described below in conjunction with the accompanying drawings in the embodiment of the present application.

It is to be noted that similar designations and letters indicate similar terms in the accompanying drawings below, so once a certain item is defined in an accompanying drawing, it does not need to be further defined and explained in subsequent accompanying drawings. Moreover, in the description of the present application, the terms "first", "second", etc., are only used for distinguishing the description and cannot be construed as indicating or implying relative importance.

Photovoltaic Array is formed by connecting a plurality of photovoltaic modules, each photovoltaic module may include a plurality of connected photovoltaic cells, and the photovoltaic array is a photovoltaic power generation system.

The photovoltaic arrays can be charged by solar energy, which is relatively clean and has a large usable capacity, so the photovoltaic array is also used in more and more scenarios. In order to make the power supply of the photovoltaic array used more stable and safer, it is needed to test the photovoltaic array before use. A current test method is to test current and voltage of loops, carry out global scanning on the photovoltaic array and compare the data with the preset value, and then determine whether there is an abnormality in the loop according to the difference value.

According to the research of the inventor of the present application, the current test method is to globally scan the current voltage of the photovoltaic array, which cannot confirm whether each group of photovoltaic branches in the photovoltaic array is not connected or the photovoltaic branches are damaged and subjected to open circuit, resulting in input failure.

Based on the above research, embodiments of the present application provide a photovoltaic array test method and system; through signal linkage determination such as determining the quantity of connected photovoltaic branches and the voltage current of the connected photovoltaic array through connector connection signals, and whether the abnormality of the photovoltaic array is caused by disconnection or input failure of the photovoltaic branch can be recognized.

In order to facilitate the understanding of the present embodiment, the test system for implementing the photovoltaic array test method disclosed in the embodiment of the present application is first described.

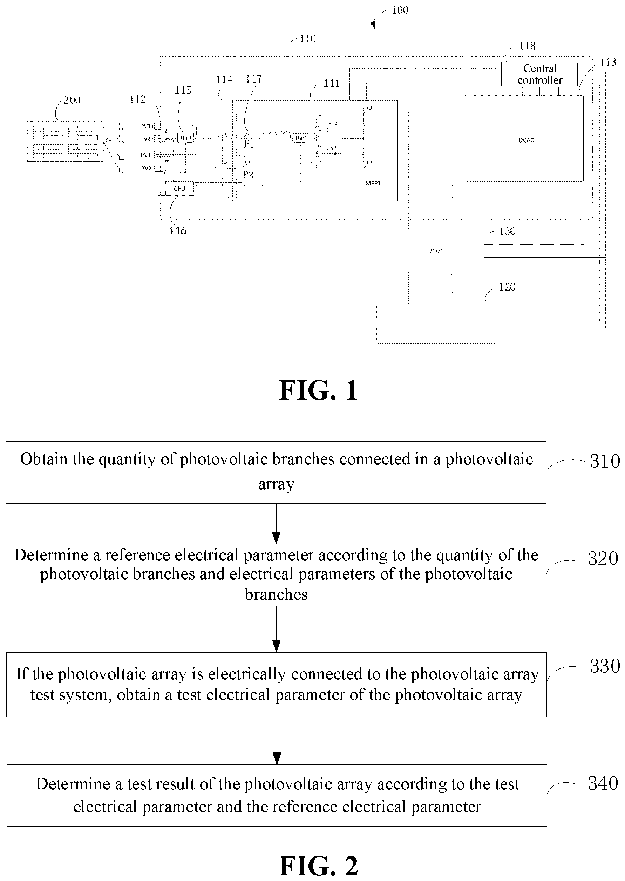

As shown in FIG. 1, the photovoltaic array test system 100 provided by the embodiment can include: a photovoltaic energy storage inverter 110.

The photovoltaic energy storage inverter 110 includes: an input interface 112, a converter 111 and a central controller 118.

The input interface 112 is configured to connect a photovoltaic array 200. The photovoltaic array 200 can include a plurality of photovoltaic branches, each photovoltaic branch is connected to at least one photovoltaic module, and the photovoltaic module is, for example, a working unit for converting solar energy into electric energy, so that the photovoltaic array in a working state can convert the solar energy into the electric energy and transmit the electric energy to the photovoltaic energy storage inverter through the input interface. The photovoltaic energy storage inverter 110 can include a plurality of input interfaces 112 (two of which are shown in FIG. 1), and each input interface 112 can be configured to connect one photovoltaic branch in the photovoltaic array 200. In one example, the input interface 112 can be a high-voltage input interface.

The converter 111 is a direct current-direct current (DC-DC) converter for example. The converter 111 can be configured to test an electrical parameter of the photovoltaic array 200 for example. The converter 111 can also be configured to convert electric energy generated by the photovoltaic array 200 for example, so that AC is generated through the photovoltaic energy storage inverter 110 to supply power to a load. In one embodiment, the converter 111 has a maximum power point tracking (MPPT) function, and the converter 111 with the MPPT function can test the power generation voltage of the connected photovoltaic array in real time and track the highest voltage and current value, so that the photovoltaic array can supply power to the load at the maximum power output.

In the embodiment, a maximum power point tracking controller can also include some elements, and the maximum power point tracking controller formed by each element can also be configured to track the maximum power point of the connected photovoltaic array. As shown in FIG. 1, the maximum power point tracking controller can also include some sensors configured to test current or voltage data in a circuit. In the example shown in FIG. 1, the maximum power point tracking controller is further connected to a Hall sensor (not marked in the figure).

When the photovoltaic energy storage inverter 110 runs, the connected photovoltaic array can be tested, including the quantity of the connected photovoltaic arrays and electrical parameters such as voltage and current of the connected photovoltaic arrays, for example, the quantity of photovoltaic branches connected from the photovoltaic array to the photovoltaic energy storage inverter can be tested, and the voltage and/or current of the photovoltaic branches can be tested.

With reference to FIG. 1 again, FIG. 1 shows that the photovoltaic array is provided with two photovoltaic branches connected to the input interface 112 of the photovoltaic energy storage inverter 110.

A first current sensor 115 is connected to a part, configured to connect to a positive electrode of each photovoltaic branch, in the input interface 112; and the first current sensor 115 can be configured to test the input current of the photovoltaic array. In a first example, the first current sensor 115 can be a Hall sensor.

As shown in FIG. 1, the photovoltaic energy storage inverter 110 further includes a manual switch 114 connected between the converter 111 and the input interface 112.

As shown in FIG. 1, the central controller 118 of the photovoltaic energy storage inverter 110 can be connected to the converter 111. The central controller 118 can acquire data obtained by testing using the maximum power point tracking function of the converter 111.

The photovoltaic energy storage inverter 110 in the embodiment can further include: a DCAC inverter 113, and the DCAC inverter 113 can be configured to convert direct current (DC) into alternating current (AC).

The DCAC inverter 113 is connected to the converter 111 and configured to convert the DC transmitted by the converter 111 into AC.

In the embodiment, the photovoltaic energy storage inverter 110 can further include a test controller 116, and the test controller 116 is connected to the input interface 112 of the photovoltaic energy storage inverter 110 and configured to test whether each input interface 112 is connected to the photovoltaic branches to form a loop.

Exemplarily, a high-voltage input interface can be connected to the test controller 116 through a low-voltage signal and configured to test a male connector and female connector connection condition of the input interface 112; after one photovoltaic branch is connected to the photovoltaic energy storage inverter 110, the corresponding high-voltage input interface is connected, a low-voltage signal loop is conducted, and then the test controller 116 can test that the photovoltaic branch is connected into the photovoltaic energy storage inverter 110.

Optionally, several interfaces, connected to a positive electrode, of the input interface 112 can be gathered to a first node P1; the input interface 112 is connected to a negative electrode and gathered to a second node P2; and the input voltage of a photovoltaic array 200 can be tested by testing the voltage between the first node P1 and the second node P2. Exemplarily, a voltage sensor can be connected between the first node P1 and the second node P2 for voltage test. In the example shown in FIG. 1, the photovoltaic voltage 117 between the first node P1 and the second node P2 can be represent the input voltage of a plurality of groups of connected photovoltaic branches.

In the embodiment, the test system can further include: a power module 120 connected to the photovoltaic energy storage inverter 110, and the power module 120 is configured to supply power to the photovoltaic array 200.

As shown in FIG. 1, the photovoltaic array test system 100 can further include a DCDC converter 130, and the DCDC converter 130 is configured to convert the input voltage into fixed voltage and output to a voltage converter of the fixed voltage. The DCDC converter 130 is connected between the photovoltaic energy storage inverter 110 and the power module 120.

As shown in FIG. 1, the central controller 118 of the photovoltaic energy storage inverter 110 can be further connected to the DCAC inverter 113, the DCDC converter 130 and the power module 120. The central controller 118 can acquire related data of the DCAC inverter 113, the DCDC converter 130 and the power module 120, and can also control the DCAC inverter 113, the DCDC converter 130 and the power module 120.

The related content of the photovoltaic array test method executed by the photovoltaic array test system 100 is described below through some methods.

With reference to FIG. 2, it is a flowchart of a photovoltaic array test method provided by an embodiment of the preset application. The steps in the method provided by the embodiment can be implemented by the photovoltaic array test system shown in FIG. 1, and the specific flow shown in FIG. 2 will be detailed below.

Step 310: Obtain the quantity of photovoltaic branches connected in a photovoltaic array.

A plurality of photovoltaic branches of the photovoltaic array are connected to a plurality of input interfaces of the photovoltaic energy storage inverter. Exemplarily, the quantity of the photovoltaic branches connected to the photovoltaic array test system in the photovoltaic array can be determined according to a loop formed by the test controller and the input interfaces in the photovoltaic array test system.

Step 320: Determine a reference electrical parameter according to the quantity of the photovoltaic branches and electrical parameters of the photovoltaic branches.

Exemplarily, the reference electrical parameter can include parameters such as voltage and current. The reference electrical parameter can represent the electrical parameters generated by the quantity of the photovoltaic branches. For example, if the quantity of the photovoltaic branches can work normally, the actually measured electrical parameters can be equal to the reference electrical parameters.

The reference electrical parameters can be computed according to the characteristics of the photovoltaic array. For example, if the theoretical output current of each photovoltaic branch is Iref, and the currently determined quantity of connected photovoltaic branches is N, the obtained reference electrical parameters include Imax=N*Iref.

Step 330: If the photovoltaic array is electrically connected to the photovoltaic array test system, monitor a test electrical parameter of the photovoltaic array.

Exemplarily, the step can include: if the photovoltaic array is in a state of supplying power to the photovoltaic array test system, monitoring the test electrical parameter inputted by the photovoltaic array to the photovoltaic array test system.

The test electrical parameter can include electrical parameters such as current and voltage inputted by the photovoltaic array.

Exemplarily, the input current of the photovoltaic array can be tested by the current sensor in the photovoltaic array test system. As shown in FIG. 1, the input current of the photovoltaic array can be monitored by the first current sensor.

Optionally, the voltage between the first node P1 and the second node P2 can be used for testing the input voltage of the photovoltaic array.

Step 340: Determine a test result of the photovoltaic array according to the test electrical parameter and the reference electrical parameters.

By taking current as an example, if the difference value between the current value in the tested electrical parameter and the current value in the reference electrical parameter is small, it is determined that the current outputted by the photovoltaic array is not abnormal. For example, if the difference value is smaller than the set threshold, it is determined that the current outputted by the photovoltaic array is not abnormal. The set threshold can be a small value set according to needs, such as 0.1 A, 0.2 A and 0.15 A. The set threshold can be a small value set based on the current value in the reference electrical parameter, for example, the set threshold is one tenth, one fifteenth and one twentieth of the current value in the reference electrical parameter.

By taking voltage as an example, if the difference value between the voltage value in the tested electrical parameter and the voltage value in the reference electrical parameter is small, it is determined that the voltage outputted by the photovoltaic array is not abnormal. For example, if the difference value is smaller than the set threshold, it is determined that the voltage outputted by the photovoltaic array is not abnormal. The set threshold can be a small value set according to needs, such as 0.1 V, 0.05 V and 0.08 V. The set threshold can be a small value set based on the voltage value in the reference electrical parameter, for example, the set threshold is one tenth, one twelfth and one seventeenth of the voltage value in the reference electrical parameter.

In the steps, the quantity of photovoltaic branches connected into the test system can be tested, thus misjudgment caused by disconnection can be avoided; and in addition, the reference electrical parameter can be determined according to the quantity of the connected photovoltaic branches, the determined reference value can have high reference level, and therefore whether a circuit of the photovoltaic array is abnormal or not can be determined more accurately.

If the photovoltaic array is electrically connected to the photovoltaic array test system, the photovoltaic array test system can be in a state of supplying power to the photovoltaic array test system, or the power module in the photovoltaic array test system is in a secondary power supply state of the photovoltaic array.

In one embodiment, if the photovoltaic array is in the state of supplying power to the photovoltaic array test system, the test electrical parameter inputted to the photovoltaic array test system by the photovoltaic array can be monitored.

On that basis, the reference electrical parameter is also a theoretical electrical parameter of the photovoltaic array in the power supply state.

The test electrical parameter of the photovoltaic array monitored in the state of supplying power to the photovoltaic array test system can be compared with the theoretical electrical parameter of the photovoltaic array in the power supply state, so as to determine the test result that the photovoltaic array is the photovoltaic array in the state of supplying power to the photovoltaic array test system.

The photovoltaic array is used as a power supply device, so that the condition of the power supply state of the photovoltaic array can be tested, whether the photovoltaic array supplies power normally can be determined, and the photovoltaic array leaving the factory can work better through the test.

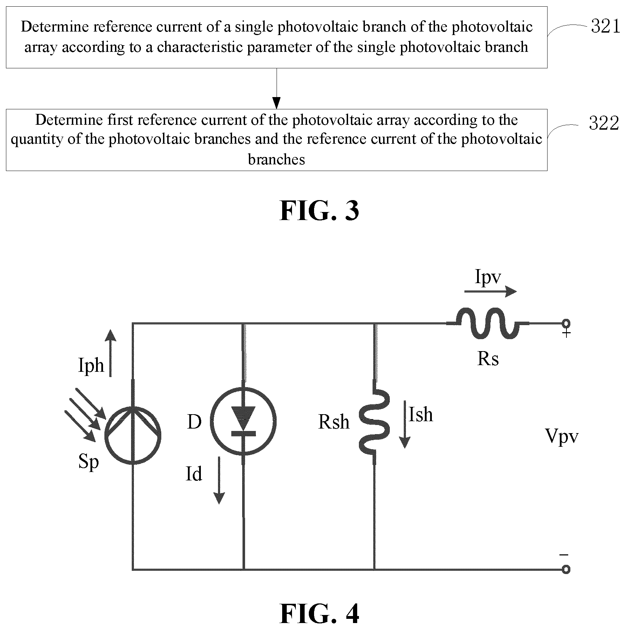

When the photovoltaic array is used as the power supply device, the photovoltaic array not only has photocurrent, but is also subjected to the influence of some components in the photovoltaic array on the current, so in order to determine more accurate reference current, not only the photocurrent is taken into account when the reference current is determined, but also the internal components of the photovoltaic branches can be taken into account. On that basis, the reference electrical parameter includes the first reference current, the electrical parameters of the photovoltaic branch include the first reference current of the photovoltaic branches, and the test electrical parameter includes the first test current. As shown in FIG. 3, step 320 can include step 321 to step 323.

Step S321: Determine reference current of a single photovoltaic branch of the photovoltaic array according to a characteristic parameter of the single photovoltaic branch.

Optionally, the reference current of the single photovoltaic branch can be pre-stored data, and when the reference current needs to be computed, the reference current of the single photovoltaic branch can be obtained according to an identifier of the currently tested photovoltaic array.

The photovoltaic branches in different photovoltaic arrays may have different or same reference currents, and therefore the reference current of the photovoltaic branches of various photovoltaic arrays can be pre-stored. For example, the identifier of each photovoltaic array and the reference current of the photovoltaic branches of the photovoltaic array can be stored in an associated mode. On that basis, the reference current of the photovoltaic branches can be searched from the pre-stored data according to the identifier of the photovoltaic array which needs to be tested currently.

Optionally, step 321 may also include: determining the first initial current of the single photovoltaic branch according to the characteristic parameter of the photovoltaic branch in a plurality of working states; and determining the reference current of the photovoltaic branch according to the first initial current in the plurality of working states.

The plurality of working states may include: a working state that the photovoltaic array is in a power supply state, a working state that the photovoltaic array is in a power supply state and the illumination borne by the photovoltaic array is different, a working state that the photovoltaic array is in different time points, etc. For example, different time points can be a time point in the afternoon with the strongest illumination, a time point in the morning with relatively weak sunlight, the time point before 4:00 p.m. in the afternoon with relatively strong sunlight.

For example, in the working state that the photovoltaic array is in different time points, the first initial current of the photovoltaic branch can be determined according to the characteristic parameters of the photovoltaic branches.

The characteristic parameters of the photovoltaic branches can include current that can be generated by a battery panel of the photovoltaic array, the current of internal modules of each photovoltaic branch of the photovoltaic array, and the like.

Exemplarily, the characteristic parameters include photocurrent and loss current of the photovoltaic branch.

Optionally, the determining first initial current of the single photovoltaic branch according to the characteristic parameter of the photovoltaic branch includes: acquiring the photocurrent generated by the single photovoltaic branch; acquiring the loss current of the single photovoltaic branch; and determining the first initial current of the photovoltaic branch according to the photocurrent and the loss current.

As shown in FIG. 4, it shows an equivalent circuit diagram of a photovoltaic branch. In the example shown in FIG. 4, the equivalent circuit includes: a solar panel Sp, a diode D connected in parallel with the solar panel Sp, an equivalent parallel load Rsh, and an equivalent series load Rs.

The first initial current is the output current of the photovoltaic branches, and the output current can be computed by the following formula:

$$Ipv = Iph - Id - Ish = Iph - Ipvo\{exp[q(Vpv + Ipv*Rs)/AKT]\} - (Vpv + Ipv*Rs)/Rsh;$$

in which, Ipv represents the output current of the photovoltaic branch circuit at any moment; Iph represents the photocurrent generated by the cell panel of the photovoltaic branch; Id represents the current flowing through the diode D; Ish represents the current flowing through the internal equivalent parallel load; Ipvo represents the second saturation current; Vpv represents the open circuit voltage of the photovoltaic branch; A represents a diode factor; K represents a Boltzmann constant; and T represents an absolute temperature.

In different operating states, for example, under different illumination conditions, the photocurrents generated by the panels of the photovoltaic branches may be different, which results in different output currents Ipv of the photovoltaic branches.

Definitely, FIG. 4 is only an exemplary equivalent circuit, which may contain more load elements depending on different actual photovoltaic branches.

Optionally, the current corresponding to the power of the photovoltaic branch being greater than a set power can be screened out from the first initial current in the plurality of working states as the reference current of the photovoltaic branches.

The set power may be a value smaller than the maximum power of the photovoltaic branch. For example, the set power is equal to ninety percent, eighty-five percent; if the power computed through a plurality of first initial currents is larger than the set power by only one, the first initial currents are used as the reference currents of the photovoltaic branches; if the power computed through the plurality of first initial currents is more than the set power, one of the plurality of first initial currents can be randomly selected as the first reference current, and the average value of the plurality of first initial currents can be used as the first reference current.

Optionally, the first reference current may be the current of a maximum power point of the photovoltaic branch. For example, the power value corresponding to the first initial current in each operating state may be computed, and the first initial current corresponding to the maximum power value may be screened out as the reference current of the photovoltaic branch.

Step 322: Determine first reference current of the photovoltaic array according to the quantity of the photovoltaic branches and the reference current of the photovoltaic branches.

Exemplarily, the quantity of the photovoltaic branches may be multiplied by the reference current of the photovoltaic branch, so as to obtain the first reference current of the photovoltaic array.

In the embodiment, the step 340 may be implemented to include: comparing the first test current with the first reference current; and if the difference between the first test current and the first reference current is greater than a first current threshold, determining that the photovoltaic array is abnormal.

The first test current is a current value which is inputted into the photovoltaic array test system by the photovoltaic array and is monitored when the photovoltaic array supplies power to the photovoltaic array test system.

The first current threshold is a value set as needed, for example, the first current threshold may be a threshold determined according to the first reference current, for example, the first current threshold may be the same value as one tenth of the first reference current, one eighth of the first reference current, one twelfth of the first reference current, one fifteenth of the first reference current. Definitely, the first current threshold may not be the first reference current, but may be a smaller value set as needed, for example, the first current threshold may be 0.1 A, 1 A, 1.5 A, and 2 A.

When the reference current is determined, the quantity of the photovoltaic branches effectively connected to the photovoltaic array can be included in computation, so that the computed first reference current can be more accurate, and the result of testing the photovoltaic array can be more accurate. Further, when determining the first reference current, the loss current existing in the photovoltaic array is also taken into account, so that the determined first reference current can be more accurate, and further, the result of testing the photovoltaic array can be more accurate.

In order to make the test result of the photovoltaic array more comprehensive and accurate, the reference electrical parameter includes the first reference voltage, and the test electrical parameter includes the first test voltage.

The first test voltage may be a voltage value inputted by the photovoltaic array to the photovoltaic array test system, which is monitored when the photovoltaic array supplies power to the photovoltaic array test system.

Exemplarily, step 340 may include: comparing the first test voltage with the first reference voltage, and if a difference value between the first test voltage and the first reference voltage is greater than a first voltage threshold, determining that the photovoltaic array is abnormal.

In an example shown in FIG. 4, the first reference voltage can be determined from open-circuit voltages Vpv in the plurality of working states.

For example, based on the first reference voltage, power in each working state can be computed according to the open-circuit voltages Vpv determined in the multiple working states and the output current Ipv of the photovoltaic branches, and the open-circuit voltage Vpv corresponding to the maximum power value is screened out to serve as the first reference voltage of the photovoltaic branches.

The first voltage threshold can be set to be a small value as required. For example, the first voltage threshold can be a threshold determined according to the first reference voltage, for example, the first voltage threshold can be one tenth of the first reference voltage, one eighth of the first reference voltage, one twelfth of the first reference voltage, one fifteenth of the first reference voltage and the like. Definitely, the first voltage threshold can also be a small value directly set as required without taking the first reference voltage as a reference value, for example, the first voltage threshold can be 0.5 V, 0.8 V, and 0.9 V.

By testing the voltage of a photovoltaic array, the test result of the photovoltaic array can be more comprehensive, and the performance of the photovoltaic array leaving the factory can be more reliable.

In an embodiment, if the power module of the photovoltaic array test system is in a state of supplying power to the photovoltaic array, the test electrical parameter of the photovoltaic array can be monitored.

On that basis, the reference electrical parameter is also a theoretical electrical parameter of the photovoltaic array in the power supply state. In this state, a battery panel of the photovoltaic array cannot generate photocurrent.

The test electrical parameter monitored when the photovoltaic array supplies power to the photovoltaic array test system can be compared with the theoretical electrical parameter of the photovoltaic array in the power supply state to determine a test result of the photovoltaic array when the photovoltaic array supplies power to the photovoltaic array test system.

The photovoltaic array is used as a power supply device, so that the condition of the power supply state of the photovoltaic array can be tested, whether the power supply of the photovoltaic array is normal or not can be determined, and the photovoltaic array leaving the factory can work better through the test.

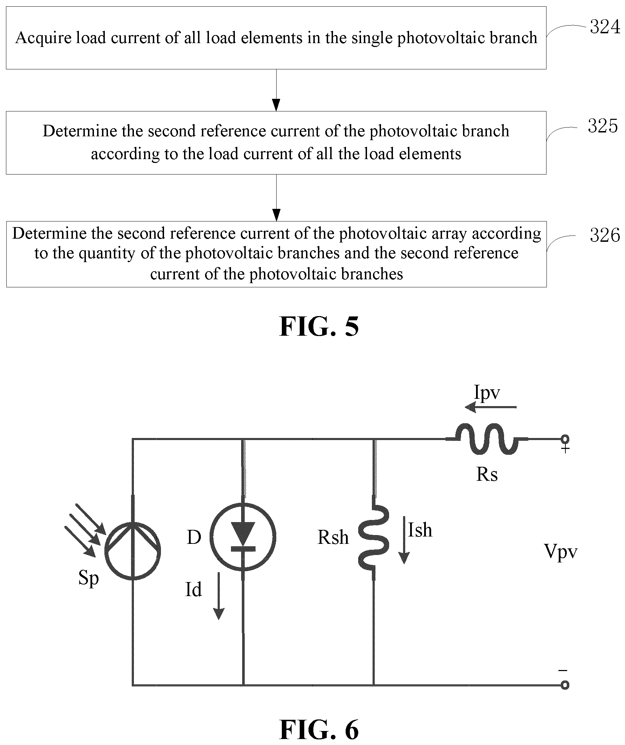

When the photovoltaic array is not used as the power supply device and but serves as the load, the photovoltaic array does not have the photocurrent. Therefore, in order to determine more accurate reference current, the photocurrent does not need to be considered when the reference current is determined, and only the internal components of the photovoltaic branch need to be considered. The reference electrical parameter includes second reference current, and the test electrical parameter includes second test current. As shown in FIG. 5, step 320 can include step 324 to step 326.

Step 324: Acquire load current of all load elements in the single photovoltaic branch.

Exemplarily, the load current of all load elements of the photovoltaic branches can be obtained.

As shown in FIG. 6, FIG. 6 shows an equivalent circuit diagram of one photovoltaic branch in secondary power supply. In the example shown in FIG. 6, the current direction of an equivalent series load Rs is opposite to the current direction of an equivalent series load Rs in the example shown in FIG. 4, and a battery panel Sp does not generate the photocurrent.

Step 325: Determine the second reference current of the photovoltaic branch according to the load current of all the load elements.

Exemplarily, the second reference current of the photovoltaic branches can be equal to the sum of all load current.

As shown in FIG. 6, the second reference current of the photovoltaic branches can be equal to $Ipv=Id+Ish$; Ipv represents an output current of the photovoltaic branches at any moment; Id represents current flowing through the diode D; and Ish represents current flowing through an internal equivalent parallel load.

Step 326: Determine the second reference current of the photovoltaic array according to the quantity of the photovoltaic branches and the second reference current of the photovoltaic branches.

Exemplarily, the quantity of the photovoltaic branches can be multiplied by the second reference current of the photovoltaic branches to obtain the second reference current of the photovoltaic array.

Optionally, the second reference current of the photovoltaic branches can be pre-stored, and when the second reference current of the photovoltaic array needs to be computed, the second reference current of the photovoltaic branches can be obtained from a pre-stored file. For example, the second reference current of the photovoltaic branches and an identifier of the photovoltaic array are stored in association manner, and when the second reference current of the photovoltaic branches needs to be obtained, the second reference current of the photovoltaic branches can be searched in the pre-stored file according to the identifier of the photovoltaic array.

In the embodiment, the step 340 can be implemented as: comparing the second test current with the second reference current, and if the difference value between the second test current and the second reference current is greater than the second current threshold, determining that the photovoltaic array is abnormal.

The second test current is a current value of the photovoltaic array in a state of not supplying power.

The second current threshold can be the same as or different from the first current threshold. For example, the second current threshold can be a threshold determined according to the second reference current, for example, the second current threshold can be one tenth of the second reference current, one eighth of the second reference current, one twelfth of the second reference current and one fifteenth of the second reference current. Definitely, the second current threshold can also be a small value directly set as need instead of taking the second reference current as the reference value, for example, the second current threshold can be 0.8 A, 1 A and 1.5 A.

In order to make the test result of the photovoltaic array more comprehensive and accurate, the reference electrical parameter includes second reference voltage, and the test electrical parameter includes second test voltage.

The second test voltage can be a voltage value outputted by the photovoltaic array monitored in a state that the photovoltaic array is not used as the power supply device.

Exemplarily, step 340 may include: comparing the second test voltage with the second reference voltage, and if a difference value between the second test voltage and the second reference voltage is greater than a second voltage threshold, determining that the photovoltaic array is abnormal.

The second voltage threshold can be the same as or different from the first voltage threshold. Definitely, the second voltage threshold can be set to be a small value as needed. For example, the second voltage threshold can be a threshold determined according to the first reference voltage, for example, the second voltage threshold can be one tenth of the first reference voltage, one eighth of the first reference voltage, one twelfth of the first reference voltage, one fifteenth of the first reference voltage and the like. Definitely, the second voltage threshold can also be a small value directly set as needed instead of taking the first reference voltage as the reference value, for example, the second voltage threshold can be 0.5 V, 0.3 V, and 0.4 V.

By testing the photovoltaic array in a multi-dimensional mode, the test result can be more reliable, and the reliability of the photovoltaic array which is tested to be qualified can be improved.

Through steps 310-340, the current and voltage of the photovoltaic array which is confirmed to be effectively connected can be tested so as to determine whether input failure is caused by damage and open circuit. Therefore, the method provided by the embodiment may further include: comparing the quantity of the connected photovoltaic branches with the total quantity of photovoltaic branches contained in the photovoltaic array to determine whether the quantity of the connected photovoltaic branches is smaller than the total quantity of photovoltaic branches contained in the photovoltaic array or not.

If the quantity of the connected photovoltaic branches is smaller than the total quantity of photovoltaic branches contained in the photovoltaic array, it is determined that there is an abnormal connection in the photovoltaic array.

Exemplarily, if the photovoltaic branches of the photovoltaic array totally includes N photovoltaic branches, the quantity of currently connected branches is N, but the quantity of tested photovoltaic branches is M, and M is smaller than N, it is indicated that there are some invalid connections, and it can be determined that the photovoltaic array has connection abnormity.

Through the method according to the embodiment of the present application, the quantity of the photovoltaic branches which are effectively connected can be tested, through linkage judgment of voltage and current signals of the connected photovoltaic branches, the abnormal condition of the photovoltaic array can be recognized, and the abnormal type of the photovoltaic array can be more accurately positioned.

The foregoing is only a preferred embodiment of the present application and is not intended to limit the present application, which may be subject to various changes and variations for those skilled in the art. Any modification, equivalent replacement, improvement, and the like made within the spirit and principle of the present application should be encompassed within the scope of protection of the present application. It should be noted that: similar reference numerals and letters represent similar items in the following figures, so that once an item is defined in a figure, it will not be further defined and explained in subsequent figures.

While the above description merely provides specific embodiments of the present application, the scope of protection of the present application is not limited to the specific embodiments. Any person skilled in the art can easily conceive of alterations or replacements within the technical scope disclosed in the present application. All these alterations or replacements should be encompassed within the scope of protection of the present application. Therefore, the scope of protection of the present application shall be determined by the scope of protection of the claims.

**Claims**

1. A photovoltaic array test method, applied to a photovoltaic array test system, the photovoltaic array test method comprising:

   obtaining the quantity of photovoltaic branches connected in a photovoltaic array;
   determining a reference electrical parameter according to the quantity of the photovoltaic branches and electrical parameters of the photovoltaic branches;
   if the photovoltaic array is electrically connected to the photovoltaic array test system, obtaining a test electrical parameter of the photovoltaic array; and
   determining a test result of the photovoltaic array according to the test electrical parameter and the reference electrical parameter.

2. The method according to claim 1, wherein the step of if the photovoltaic array is electrically connected to the photovoltaic array test system, obtaining a test electrical parameter of the photovoltaic array comprises:
   if the photovoltaic array is in a state of supplying power to the photovoltaic array test system, monitoring the test electrical parameter inputted by the photovoltaic array to the photovoltaic array test system.

3. The method according to claim 2, wherein the reference electrical parameter comprises first reference current; the electrical parameters of the photovoltaic branches comprise first reference current of the photovoltaic branches; and the test electrical parameter comprises first test current;
   the determining a reference electrical parameter according to the quantity of the photovoltaic branches and electrical parameters of the photovoltaic branches comprises:

   determining reference current of a single photovoltaic branch of the photovoltaic array according to a characteristic parameter of the single photovoltaic branch; and
   determining first reference current of the photovoltaic array according to the quantity of the photovoltaic branches and the reference current of the photovoltaic branches; and
   the determining a test result of the photovoltaic array according to the test electrical parameter and the reference electrical parameter comprises:
   comparing the first test current with the first reference current; and if a difference value between the first test current and the first reference current is greater than a first current threshold, determining that the photovoltaic array is abnormal.

4. The method according to claim 3, wherein the determining reference current of a single photovoltaic branch of the photovoltaic array according to an electrical parameter of the single photovoltaic branch comprises:

   determining first initial current of the single photovoltaic branch according to the characteristic parameter of the photovoltaic branch in a plurality of working states; and
   determining the reference current of the photovoltaic branch according to the first initial current in the plurality of working states.

5. The method according to claim 4, wherein the characteristic parameter comprises photocurrent and loss current of the photovoltaic branch; and
   the determining first initial current of the single photovoltaic branch according to the characteristic parameter of the photovoltaic branch comprises:

   acquiring the photocurrent generated by the single photovoltaic branch;
   acquiring the loss current of the single photovoltaic branch; and
   determining the first initial current of the photovoltaic branch according to the photocurrent and the loss current.

6. The method according to claim 5, wherein the determining the reference current of the photovoltaic branch according to the first initial current in the plurality of working states comprises:
   screening out the current corresponding to the power of the photovoltaic branch being greater than a set power from the first initial current in the plurality of working states as the reference current of the photovoltaic branch.

7. The method according to claim 2, wherein the reference electrical parameter comprises first reference voltage, and the test electrical parameter comprises first test voltage; and

the determining a test result of the photovoltaic array according to the test electrical parameter and the reference electrical parameter comprises:

comparing the first test voltage with the first reference voltage, and if a difference value between the first test voltage and the first reference voltage is greater than a first voltage threshold, determining that the photovoltaic array is abnormal.

8. The method according to claim 1, wherein the photovoltaic array test system comprises: a power module; and

the step of if the photovoltaic array is electrically connected to the photovoltaic array test system, obtaining a test electrical parameter of the photovoltaic array comprises:

if the power module of the photovoltaic array test system is in a state of supplying power to the photovoltaic array, obtaining the test electrical parameter of the photovoltaic array.

9. The method according to claim 8, wherein the reference electrical parameter comprises second reference current; the electrical parameters of the photovoltaic branches comprise second reference current of the photovoltaic branches; and the test electrical parameter comprises second test current;

the determining a reference electrical parameter according to the quantity of the photovoltaic branches and electrical parameters of the photovoltaic branches comprises:

acquiring the load current of all load elements in the single photovoltaic branch;
determining the second reference current of the photovoltaic branch according to the load current of all the load elements; and
determining the second reference current of the photovoltaic array according to the quantity of the photovoltaic branches and the second reference current of the photovoltaic branches; and
the determining a test result of the photovoltaic array according to the test electrical parameter and the reference electrical parameter comprises:
comparing the second test current with the second reference current, and if a difference value between the second test current and the second reference current is greater than a second current threshold, determining that the photovoltaic array is abnormal.

10. The method according to claim 8, wherein the reference electrical parameter comprises second reference voltage, and the test electrical parameter comprises second test voltage; and

the determining a test result of the photovoltaic array according to the test electrical parameter and the reference electrical parameter comprises:

comparing the second test voltage with the second reference voltage, and if a difference value between the second test voltage and the second reference voltage is greater than a second voltage threshold, determining that the photovoltaic array is abnormal.

11. The method according to any one of claims 1 to 10, further comprising:

comparing the quantity of the connected photovoltaic branches with the total quantity of photovoltaic branches contained in the photovoltaic array to determine whether the quantity of the connected photovoltaic branches is smaller than the total quantity of photovoltaic branches contained in the photovoltaic array; and
if the quantity of the connected photovoltaic branches is smaller than the total quantity of photovoltaic branches contained in the photovoltaic array, determining that there is an abnormal connection in the photovoltaic array.

12. A photovoltaic array test system, comprising a photovoltaic energy storage inverter, wherein the photovoltaic energy storage inverter comprises: an input interface, a converter and a central controller;

the input interface is configured to connect the photovoltaic array;
the converter is configured to test an electrical parameter of the photovoltaic array; and
the photovoltaic energy storage inverter executes steps of the method according to any one of claims 1 to 10 during operation.

13. The photovoltaic array test system according to claim 12, further comprising: a power module connected to the photovoltaic energy storage inverter; wherein

the power module is configured to supply power to the photovoltaic array.

**FIG. 1**

| Obtain the quantity of photovoltaic branches connected in a photovoltaic array | 310 |
| Determine a reference electrical parameter according to the quantity of the photovoltaic branches and electrical parameters of the photovoltaic branches | 320 |
| If the photovoltaic array is electrically connected to the photovoltaic array test system, obtain a test electrical parameter of the photovoltaic array | 330 |
| Determine a test result of the photovoltaic array according to the test electrical parameter and the reference electrical parameter | 340 |

**FIG. 2**

Determine reference current of a single photovoltaic branch of the photovoltaic array according to a characteristic parameter of the single photovoltaic branch — 321

Determine first reference current of the photovoltaic array according to the quantity of the photovoltaic branches and the reference current of the photovoltaic branches — 322

**FIG. 3**

**FIG. 4**

Acquire load current of all load elements in the single photovoltaic branch — 324

Determine the second reference current of the photovoltaic branch according to the load current of all the load elements — 325

Determine the second reference current of the photovoltaic array according to the quantity of the photovoltaic branches and the second reference current of the photovoltaic branches — 326

**FIG. 5**

Ipv

Rs

Sp

D

Id

Rsh

Ish

Vpv

**FIG. 6**

## INTERNATIONAL SEARCH REPORT

<table>
<tr><td colspan="2">International application No.</td></tr>
<tr><td colspan="2">PCT/CN2022/121866</td></tr>
</table>

### A. CLASSIFICATION OF SUBJECT MATTER

H02S50/10(2014.01)i

According to International Patent Classification (IPC) or to both national classification and IPC

### B. FIELDS SEARCHED

Minimum documentation searched (classification system followed by classification symbols)

IPC:H02S G01R

Documentation searched other than minimum documentation to the extent that such documents are included in the fields searched

Electronic data base consulted during the international search (name of data base and, where practicable, search terms used)

CNABS, CNTXT, CNKI, 万方 WANFANG: 光伏, 阵列, 矩阵, 测试, 检测, 标准, 基准, 理论, 参考, 计算, 电流, 电压, 电特性, 电性, 数目, 数量, 个数, 块数, 支路, 对比, 比较, 比对, 大于, 小于, 异常, 故障, 接入, 脱落, 松动, 掉落, 掉线 VEN, USTXT, WOTXT, EPTXT: photovoltaic, array, detect, measure, test, reference, fiducial, current, voltage, amount, number, branch circuit, compare, more than, less than, fault, abnormal, connnect, loose, exfoliation

### C. DOCUMENTS CONSIDERED TO BE RELEVANT

| Category* | Citation of document, with indication, where appropriate, of the relevant passages | Relevant to claim No. |
|---|---|---|
| Y | CN 207543070 U (CECEP (SHIZUISHAN) PHOTOVOLTAIC AGRICULTURAL TECHNOLOGY CO., LTD.) 26 June 2018 (2018-06-26) description, paragraph [0014], and figures 1 and 2 | 1-13 |
| Y | CN 113708726 A (GUIZHOU INSTITUTE OF TECHNOLOGY) 26 November 2021 (2021-11-26) description, paragraphs 49-82, and figures 1-2 | 1-13 |
| Y | KR 101402045 B1 (DAEYANG E&C CO., LTD.) 03 June 2014 (2014-06-03) description, paragraphs 13-14 and 28-40, and figures 1-2 | 1-13 |
| A | CN 111342772 A (SHENYANG FURUN SOLAR TECHNOLOGY DEVELOPMENT CO., LTD.) 26 June 2020 (2020-06-26) entire document | 1-13 |
| A | CN 107733357 A (SUZHOU RADIANT PHOTOVOLTAIC TECHNOLOGY CO., LTD.) 23 February 2018 (2018-02-23) entire document | 1-13 |

☑ Further documents are listed in the continuation of Box C.      ☑ See patent family annex.

| | |
|---|---|
| * Special categories of cited documents: | "T" later document published after the international filing date or priority date and not in conflict with the application but cited to understand the principle or theory underlying the invention |
| "A" document defining the general state of the art which is not considered to be of particular relevance | |
| "D" document cited by the applicant in the international application | "X" document of particular relevance; the claimed invention cannot be considered novel or cannot be considered to involve an inventive step when the document is taken alone |
| "E" earlier application or patent but published on or after the international filing date | |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | "&" document member of the same patent family |
| "P" document published prior to the international filing date but later than the priority date claimed | |

| Date of the actual completion of the international search | Date of mailing of the international search report |
|---|---|
| 05.30.2023 | 20 June 2023 |

| Name and mailing address of the ISA/CN | Authorized officer |
|---|---|
| China National Intellectual Property Administration (ISA/CN) China No. 6, Xitucheng Road, Jimenqiao, Haidian District, Beijing 100088 | |
| | Telephone No. |

Form PCT/ISA/210 (second sheet) (July 2022)

**INTERNATIONAL SEARCH REPORT**

| International application No. |
| --- |
| **PCT/CN2022/121866** |

**C.    DOCUMENTS CONSIDERED TO BE RELEVANT**

| Category* | Citation of document, with indication, where appropriate, of the relevant passages | Relevant to claim No. |
| --- | --- | --- |
| A | CN 113872526 A (GUIZHOU INSTITUTE OF TECHNOLOGY) 31 December 2021 (2021-12-31)<br>      entire document | 1-13 |
| A | CN 209964016 U (GUANGDONG ZHAO YANG SOLAR TECHNOLOGY CO., LTD.) 17 January 2020 (2020-01-17)<br>      entire document | 1-13 |
| A | CN 109936335 A (CHONGQING UNIVERSITY) 25 June 2019 (2019-06-25)<br>      entire document | 1-13 |
| A | CN 214045571 U (ZHEJIANG YINGDA WEIXIN ELECTRONICS CO., LTD.) 24 August 2021 (2021-08-24)<br>      entire document | 1-13 |

Form PCT/ISA/210 (second sheet) (July 2022)

**INTERNATIONAL SEARCH REPORT**
Information on patent family members

International application No.

**PCT/CN2022/121866**

| Patent document cited in search report | | | Publication date (day/month/year) | Patent family member(s) | | | Publication date (day/month/year) |
|---|---|---|---|---|---|---|---|
| CN | 207543070 | U | 26 June 2018 | None | | | |
| CN | 113708726 | A | 26 November 2021 | None | | | |
| KR | 101402045 | B1 | 03 June 2014 | None | | | |
| CN | 111342772 | A | 26 June 2020 | CN | 212278194 | U | 01 January 2021 |
| CN | 107733357 | A | 23 February 2018 | WO | 2018028005 | A1 | 15 February 2018 |
| | | | | CN | 107733357 | B | 25 June 2019 |
| CN | 113872526 | A | 31 December 2021 | None | | | |
| CN | 209964016 | U | 17 January 2020 | None | | | |
| CN | 109936335 | A | 25 June 2019 | None | | | |
| CN | 214045571 | U | 24 August 2021 | WO | 2022156619 | A1 | 28 July 2022 |

Form PCT/ISA/210 (patent family annex) (July 2022)